# EUROPEAN PATENT SPECIFICATION

(11) **EP 1 875 781 B1**
(45) Date of publication and mention of the grant of the patent: **08.10.2008**
(21) Application number: 06727933.1
(22) Date of filing: 13.04.2006
(51) Int. Cl.: H05B 33/14, C09K 11/08, C09K 11/77

(54) **ILLUMINATION SYSTEM COMPRISING A CERAMIC LUMINESCENCE CONVERTER**
BELEUCHTUNGSSYSTEM MIT EINEM KERAMISCHEN LUMINESZENZUMWANDLER
SYSTEME D'ECLAIRAGE COMPRENANT UN CONVERTISSEUR DE LUMINESCENCE CERAMIQUE

(30) Priority: 20.04.2005 EP 05103200
(43) Date of publication of application: 09.01.2008
(73) Proprietor: Philips Intellectual Property & Standards GmbH, 20099 Hamburg (DE); Koninklijke Philips Electronics N.V., 5621 BA Eindhoven (NL)
(72) Inventor: SCHMIDT, Peter Philips Intellectual Property, 52066 Aachen (DE)
(74) Representative: Bekkers, Joost J.J
(86) International application number: PCT/IB2006/051165
(87) International publication number: WO 2006/111907

(56) References cited:
- WO-A2-03/107441
- US-A- 4 029 983
- US-A1- 2004 145 308
- US-A1- 2005 023 546
- US-B1- 6 717 353

## Description

### BACKGROUND OF THE INVENTION

The present invention generally relates to an illumination system comprising a radiation source and a ceramic luminescence converter. The invention also relates to a ceramic luminescence converter for use in such illumination system.

More particularly, the invention relates to an illumination system and a ceramic luminescence converter for the generation of specific, colored light, including white light, by luminescent down conversion and additive color mixing based an a ultraviolet or blue radiation emitting radiation source. A light- emitting diode as a radiation source is especially contemplated.

Today light emitting illumination systems comprising visible colored light emitting diodes as radiation sources are used single or in clusters for all kind of applications where rugged, compact, lightweight, high efficiency, long- life, low voltage sources of white or colored illumination are needed

Such applications comprise *inter alia* illumination of small LCD displays in consumer products such as cellular phones, digital cameras and hand held computers. Pertinent uses include also status indicators on such products as computer monitors, stereo receivers, CD players, VCRs, and the like. Indicators are also found in systems such as instrument panels in aircraft, trains, ships, cars, etc.

Multi-color combinations of pluralities of visible colored light emitting LEDs in addressable arrays containing hundreds or thousands of LED components are found in large area displays such as full color video walls and also as high brightness large-area outdoor television screens.

Arrays of amber, red, and blue-green emitting LEDs are also increasingly used as traffic lights or in effect lighting of buildings.

Conventional visible colored light emitting LEDs, however, are typically subject to low yield and are considered difficult to fabricate with uniform emission characteristics from batch to batch. The LEDs can exhibit large wavelength variations across the wafer within a single batch, and in operation can exhibit strong wavelength and emission variations with operation conditions such as drive current and temperature.

Therefore, when generating white light with an arrangement comprising visible colored light emitting diodes, there has been such a problem that white light of the desired tone cannot be generated due to variations in the tone, luminance and other factors of the visible colored light emitting diodes.

It is known to convert the color of light emitting diodes emitting in the UV to blue range of the electromagnetic spectrum by means of a luminescent material comprising a phosphor to provide a visible white or colored light illumination.

Phosphor-converted "white" LED systems have been based in particular on the dichromatic (BY) approach, mixing yellow and blue colors, in which case the yellow secondary component of the output light may be provided by a yellow phosphor and the blue component may be provided by a phosphor or by the primary emission of a blue LED.

Likewise white illumination systems have been based on the trichromatic (RGB) approach, i.e. on mixing three colors, namely red, green and blue, in which case the red and green component may be provided by a phosphor and the blue component by the primary emission of a blue-emitting LED.

As recent advances in light-emitting diode technology have yielded very efficient light-emitting diodes emitting on the near UV to blue range of the electromagnetic spectrum , today a variety of colored and white-emitting phosphor converted light emitting diodes are on the market, challenging traditional incandescent or fluorescent lighting.

Designing luminescent material for use in such devices is a new challenge, as there are few luminescent materials with an absorption spectrum in the near UV/blue range of the electromagnetic spectrum available, that can efficiently convert said near-UV/blue radiation to visible colored or white light, while maintaining long- term stability.

With regard luminescent materials emitting yellow, amber and red light, phosphors comprising europium(II) or cerium(III) as activators in any kind of host lattice are known to satisfy the criteria of high absorption in the near UV/blue range of the electromagnetic spectrum.

WO2003095588 A1 discloses light-emitting components such as light-emitting diodes (LEDs) and laser diodes coated with luminescent materials comprising europium(II)-activated calcium strontium sulfide with a short decay time and a high thermal quenching temperature. Depending on their special composition such sulfides will convert near UV/blue radiation into yellow, amber and red visible light.

Yet, in prior art it was annotated, that sulfide-based phosphors such as earth alkaline sulfides are less desirable for lighting applications, especially for LED applications, because they interact with the encapsulating resin system, and particularly suffer from hydrolytic attack, see US6682663 B2.

US 2005/0023546 A1 discloses phosphors useful in the manufacture of white light emitting diodes. The phosphors are described by the formulae: MSₓSe_{y}: B, in which x, and y are each independently any value between about 0 and about 1, subject to the proviso that the sum of x and y is equal to any number in the range of between about 0.75 and about 1.25; M is at least one of Be, Mg, Ca, Sr, Ba, Zn, excepting Zn alone; and wherein the activator(s) B comprises one or more elements selected from the group consisting of: Eu, Ce, Cu, Ag, Al, Tb, Sb, Bi, K, Na, Cl, F, Br, I, Mg, Pr, and Mn, including mixtures comprising any two, any three, any four, any five, any six, any seven, or more of these elements in any proportion, and wherein the elements in these mixtures may each independently be present in any amount between 0.0001 % and about 10% in mole percent based on the total molar weight of said composition.

### SUMMARY OF THE INVENTION

It is therefore an object of the present invention to provide an illumination system for generating of white light, which has true color rendition and is durable and long-living.

According to another object of the invention an illumination system for generating of yellow, amber and red light is provided.

It is a further object of the invention to provide a yellow, amber and red emitting luminescent material which is excitable at wavelengths around 200 to 500 nm, preferably 400 to 500 nm, provides suitable light extraction efficiency and transparency together with high chemical and thermal stability up to at least 100 °C.

Thus the present invention provides an illumination system, comprising a radiation source and a monolithic ceramic luminescence converter comprising at least one phosphor capable of absorbing a part of light emitted by the radiation source and emitting light of wavelength different from that of the absorbed light; wherein said at least one phosphor is an alkaline earth metal sulfide of general formula AE_{1-z}S_{1-y}Se_{y}:A_{z} , wherein AE is as least one earth alkaline metal selected from the group of Mg, Ca, Sr and Ba, 0 ≤ y <1 and 0.0005 ≤ z ≤ 0.2, activated by an activator A selected from the group of Eu(II), Ce(III), Mn(II) and Pr(III).

The new monolithic ceramic luminescence converter matches every single ideal requirement for use in illumination systems, i.e.
• Strong yellow, amber or red emission
• High quantum efficiency
• Sensitivity to both stimulation by long-wave UV and especially by visible violet/blue light
• Efficient at high operating temperatures
• Stable throughout very long operating lifetimes

Preferably the illumination system according to the invention comprises a light-emitting diode as a radiation source.

The use of a monolithic ceramic luminescence converter will allow a thinner and denser design of the phosphor converted light emitting diode without sacrificing brightness, which will minimize water intrusion and eliminate light scattering. Such thinner design will also use less phosphor materials.

In one embodiment of the invention the illumination system comprises a protective coating attached to said monolithic ceramic luminescence converter. Preferably the protective coating comprises a ceramic material, selected from the group of silica SiO₂, alumina Al₂O₃ and yttria Y₂O₃. Otherwise the protective coating may comprise a glass or a resin such as a cured silsesquioxane.

The illumination system according to the invention, wherein said a monolithic ceramic luminescence converter is a first luminescence converter element, may further comprise one or more second luminescence converter elements.

The second luminescence converter element may be a coating layer, comprising a resin-bonded phosphor pigment.

Otherwise the second luminescence converter element may be a second monolithic ceramic luminescence converter.

The invention is also concerned with a monolithic ceramic luminescence converter comprising at least one phosphor capable of absorbing a part of light emitted by the radiation source and emitting light of wavelength different from that of the absorbed light; wherein said at least one phosphor is an alkaline earth metal sulfide of general formula AE_{1-z}S_{1-y}Se_{y}:A_{z}, wherein AE is as least one earth alkaline metal selected from the group of Mg, Ca, Sr and Ba, 0 ≤ y <1 and 0.0005 ≤ z ≤ 0.2, activated by an activator A selected from the group of Eu(II), Ce(III), Mn(II) and Pr(III).

Such monolithic ceramic luminescence converter will provide adequate yellow, amber and red light for many applications, as it is not susceptible to hydrolysis that otherwise may destabilize the illumination system or degrade the systems effective life.

Thermal stability is especially desirable for LED applications as LEDs get very hot under operation. Their typical operation temperature is around 80 °C.

### DETAILED DESCRIPTION OF THE INVENTION

### Monolithic Ceramic Luminescence Converter

The present invention focuses on a monolithic ceramic luminescence converter (CLC) comprising at least one phosphor capable of absorbing a part of light emitted by the radiation source and emitting light of wavelength different from that of the absorbed light; wherein said at least one phosphor is an alkaline earth metal sulfide of general formula AE_{1-z}S_{1-y}Se_{y}:A_{z}, wherein AE is as least one earth alkaline metal selected from the group of Mg, Ca, Sr and Ba, 0 ≤ y <1 and 0.0005 ≤ z ≤ 0.2, activated by an activator A selected from the group of Eu(II), Ce(III), Mn(II) and Pr(III). Such monolithic ceramic luminescence converter is useful in any configuration of an illumination system comprising a source of primary radiation, including, but not limited to discharge lamps, fluorescent lamps, LEDs, LDs, OLEDs and X-ray tubes. As used herein, the term "radiation" encompasses radiation in the UV, IR and visible regions of the electromagnetic spectrum.

In general, a monolithic ceramic luminescence converter is a ceramic body, which emits electromagnetic radiation in the visible or near visible spectrum when stimulated by high-energy electromagnetic photons.

A monolithic ceramic luminescence converter is characterized by its typical microstructure. The microstructure of a monolithic ceramic luminescence converter is polycrystalline, i.e. an irregular conglomerate of cryptocrystalline, microcrystalline or nanocrystalline crystallites. Crystallites are grown to come in close contact and to share grain boundaries. Macroscopically the monolithic ceramic seems to be isotropic, though the polycrystalline microstructure may be easily detected by SEM (scanning electron microscopy).

The monolithic ceramic luminescence converter may also contain second phases at the grain boundaries of its crystallites that change the light scattering properties of the ceramic. The second phase material may be crystalline or vitreous.

Fully dense monolithic polycrystalline ceramic luminescence converters may be transparent or may provide at least high optical translucency with low light absorption.

### Ceramic Luminescence Converter Comprising Red -Emitting Sulfide Phosphor

The monolithic ceramic luminescence converter according to the invention comprises as a luminescent material at least one phosphor, that is an alkaline earth metal sulfide of general formula AE_{1-z}S_{1-y}Se_{y}:A_{z}, wherein AE is as least one earth alkaline metal selected from the group of Mg, Ca, Sr and Ba, 0 ≤ y <1 and 0.0005 ≤ 0.2, activated by an activator A selected from the group of Eu(II), Ce(III), Mn(II) and Pr(III). Additionally, if A is selected from the group of trivalent cations, the alkaline earth metal sulfide may also contain monovalent cations such as Li(I), Na(I), K(I), and Ag(I) for charge compensation.Such monolithic ceramic luminescence converter has a high degree of physical integrity, which property renders the material useful for machining, structuring and polishing to improve light extraction and enable light guiding effects.

This class of phosphor material is based on the activated luminescence of a sulfide of an earth alkaline metal selected from the group of magnesium, calcium, strontium, barium or combinations thereof.

The phosphor comprises a host lattice and dopant ions. The host lattice has a cubic crystal structure known as the "rocksalt"-structure, derivable from the basic cubic face centered crystal structure type, wherein all cations are octahedrically surrounded by the anions and vice versa.

As dopant ions europium or cerium are used either alone or in combination with co-activators selected from the group of manganese, praseodymium or combinations thereof.

The proportion z of the dopant ions alone or in combination with a co-activator is preferably in a range of 0.0005 < a < 0.2. When the proportion z is lower, luminance decreases because the number of excited emission centres of photoluminescence decreases and, when the a is greater than 0.2, density quenching occurs. Density quenching refers to the decrease in emission intensity that occurs when the concentration of an activation agent added to increase the luminance of the luminescent material is increased beyond an optimum level.

These activated earth alkaline metal sulfide phosphors are responsive to more energetic portions of the electromagnetic spectrum than the visible portion of the spectrum.

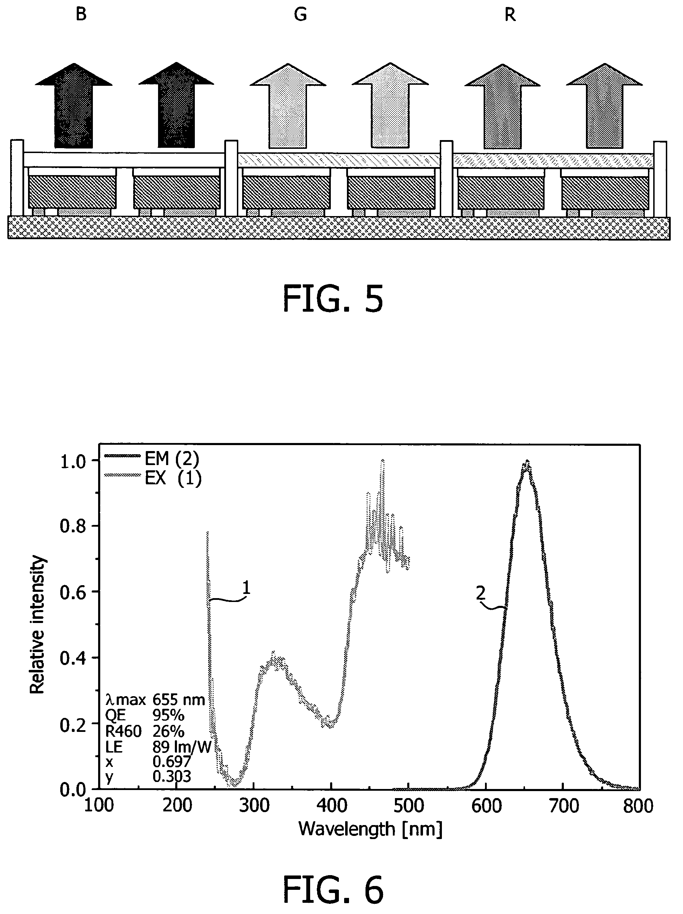

In particular, the excitation wavelength of the monolithic ceramic luminescence converter is positioned in the range of long-wavelength violet (350 to 400 nm) and short-wavelength visible light (400 to 500 nm) see Fig. 6 to 9.

Thus the luminescent material of the monolithic ceramic luminescence converter has ideal characteristics for converting primary UVA/ blue radiation of nitride semiconductor light emitting diodes into white or colored yellow, amber and red light with a peak wavelength of 515 to 625 nm.

The emission peak of a monolithic ceramic luminescence converter comprising a phosphor of the basic CaS:Eu(0.05%) composition centers at around 655nm, in the red range of the visible light, see Fig. 6.

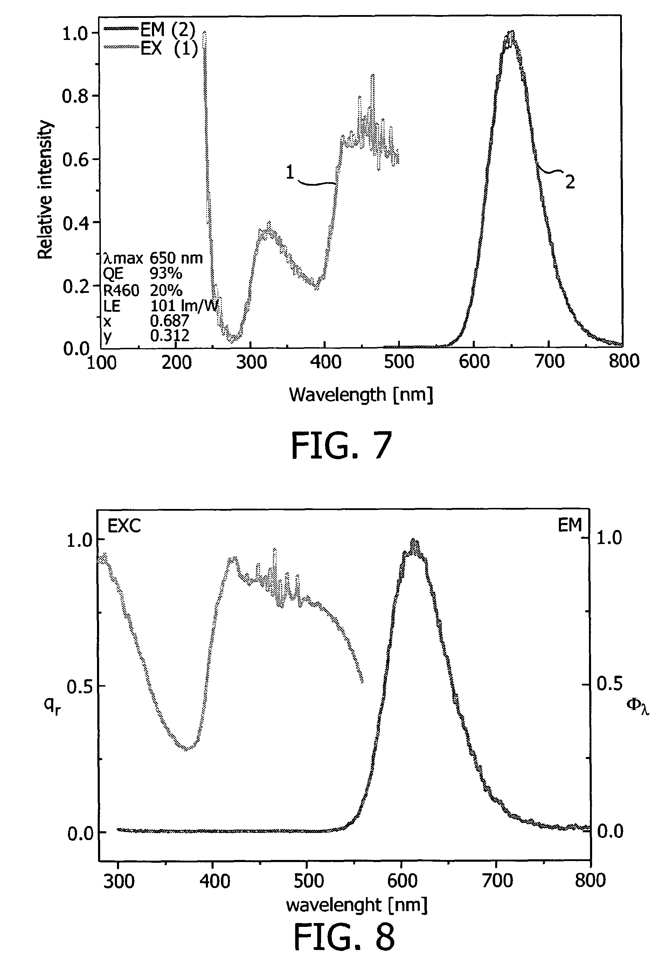

The emission peak of a monolithic ceramic luminescence converter comprising a phosphor of the Ca_{0.75}Sr_{0.25}S:Eu(0.05%) composition centers at around 650 nm, in the red range of the visible light, see Fig. 7.

The emission peak of a monolithic ceramic luminescence converter comprising a phosphor of the basic SrS:Eu(0.1 %) composition centers at around 620 nm, in the amber range of the visible light, see Fig. 8.

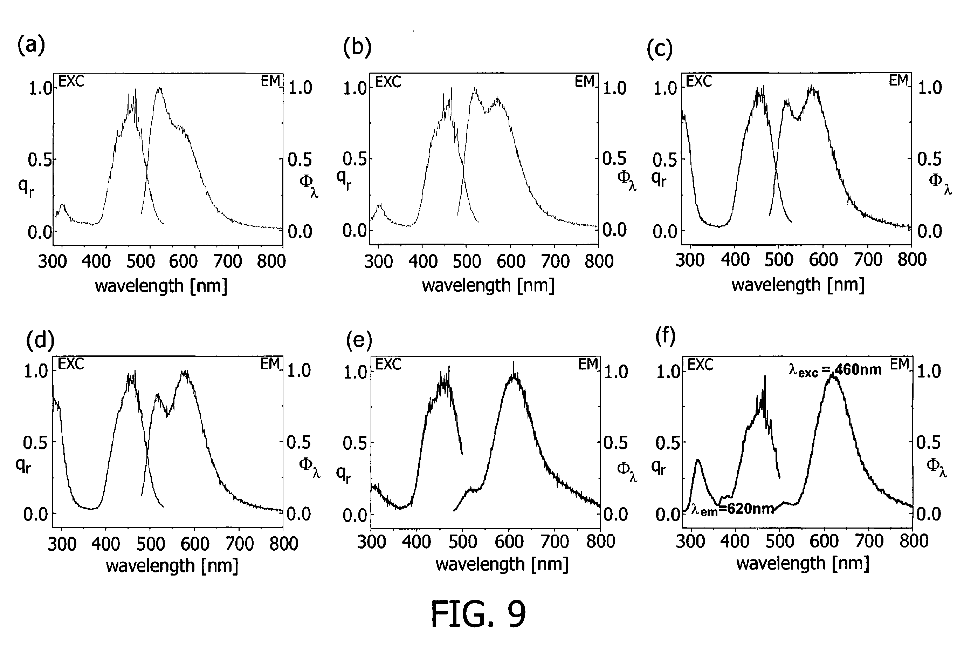

The emission peak of monolithic ceramic luminescence converters comprising phosphors of the basic CaS:Ce,Mn composition center at around 520 to 620nm, in the yellow-green to amber range of the visible light, see Fig. 9.

**Table 1: Luminescence properties of the monolithic ceramic luminescence converters comprising the CaS:Ce,Mn compositions according to Fig. 9:**

| Sample | Abs (460nm) | QE | x | y | LE[1m/W] |
|---|---|---|---|---|---|
| a) | 72 | 79 | 0.374 | 0.569 | 445 |
| b) | 78 | 80 | 0.407 | 0.548 | 433 |
| c) | 76 | 79 | 0.425 | 0.534 | 425 |
| d) | 71 | 81 | 0.432 | 0.527 | 424 |
| e) | 83 | 75 | 0.558 | 0.432 | 285 |
| f) | 76 | 67 | 0.592 | 0.401 | 248 |

| | | | | | |
|---|---|---|---|---|---|
| a) CaS:Ce (0.1%), b) CaS:Ce,Mn (0.1,0.1%), c) CaS:Ce,Mn (0.1,0.2%), d) CaS:Ce,Mn (0.1,0.3%), e) CaS:Ce,Mn (0.1,1.0%), and f) CaS:Ce,Mn (0.1,2.0%) | | | | | |

### Manufacturing of the Monolithic Ceramic Luminescence Converter

One method of manufacturing the monolithic ceramic luminescence converter according to the invention is by preparing in a first step a luminescent microcrystalline phosphor powder material and in a second step isostatically pressing the microcrystalline material into pellets and sintering the pellets at an elevated temperature and for a period of time sufficient to allow compaction to an optically translucent body.

The method for producing a luminescent microcrystalline phosphor powder is not particularly restricted, and it can be produced by any method, which will provide activated alkaline earth sulfide phosphor powders.

Three different methods of manufacturing alkaline earth sulfide luminescent phosphor powders are known from prior art:1. reduction of alkaline earth sulfate with hydrogen, 2. sulfurizing of alkaline earth carbonate or oxide with H₂S or CS₂, and 3. sulfurizing and melting method.

A preferred process for producing a phosphor according to the invention is reduction of alkaline earth sulfate with hydrogen. In this method, a solution, which includes soluble earth alkaline compounds, is chemically treated with ammonium sulfide, thereafter ammonium sulfate is added to precipitate an earth alkaline sulfate.

Thereafter the earth alkaline sulfate is dried and reduced to the earth alkaline sulfide in a stream of forming gas (5% H₂, 95% N₂) at elevated temperature. In a second reduction step the reaction product is again treated with forming gas containing hydrogen sulfide.

Thus, a series of compositions of general formula AE_{1-z}S_{1-y}Se_{y}:A_{z}, wherein AE is as least one earth alkaline metal selected from the group of Mg, Ca, Sr and Ba, 0 ≤ y <1 and 0.0005 ≤ z ≤ 0.2, activated by an activator A selected from the group of Eu(II), Ce(III), Mn(II) and Pr(III). Additionally, if A is selected from the group of trivalent cations, the alkaline earth metal sulfide may also contain monovalent cations such as Li(I), Na(I), K(I), and Ag(I) for charge compensation can be manufactured as a sinterable phosphor powder pigment.

In a specific embodiment yellow to amber emitting particles of europium(III)-activated strontium sulfide SrS:Eu(0.1 %) are prepared as nearly monodisperse phosphor powders by the following technique:
a) Synthesis of ceramic precursor powders Strontium nitrate (Merck, suprapur) is dissolved in destilled H₂O and (NH₄)₂S solution (Merck, p.a.) is added. After 12h the solution is filtered through a millipore filter. Ammonium sulfate (Merck, p.a.) is dissolved in dest. H₂O and NH₃ solution (Merck, p.a.) is added. After 12h the solution is filtered through a millipore filter. Both the nitrate and sulfate solutions are added slowly and simultaneously in equal amounts to ethanol p.a. while stirring to precipitate SrSO₄. The SrSO₄ slurry is washed 3-4 times with bidest. H₂O, then filtered and washed with ethanol. Europium nitrate (Alfa, Reacton) is dissolved in 5 ml distilled water and a slurry is formed with the SrSO₄. Then the slurry is dried and powderized, heated up to 500°C in air for 1 hr and powderized. The sulfate/nitrate mixture is partly converted to the sulfide at 1000°C for 12h in a stream of forming gas (5% H₂, 95% N₂;). The sample is then powderized and fired in a stream of a mixture of forming gas (5% H₂, 95% N₂) and dry H₂S for about 2-6 hrs. (The degree of conversion can be checked by analyzing the line width of XRD diagrams.) After reduction a highly sinterable SrS:Eu powder is obtained. The europium-activated strontium sulfide is then milled in a planet ball mill under cyclohexene for 30 min at 300 rpm and dried again.The phosphor pigments were characterized by powder X-ray diffraction (Cu, Kα-line). which showed, that the desired crystal structure had been formed.

The fine-grained sinterable microcrystalline phosphor powders obtained by these methods are used to prepare a monolithic ceramic luminescence converter according to the invention. To this aim a suitable sinterable phosphor powder as described above is subjected to a very high pressure either in combination with a treatment at elevated temperature or followed by a separate heat treatment. Uniaxial pressing is preferred.

Especially preferred is a hot uniaxial pressure treatment or otherwise cold isostatic pressure treatment followed by sintering. A combination of cold isostatic pressing and sintering followed by hot isostatic pressing may also be applied.

Careful supervision of the densification process is necessary to control grain growth and to remove residual pores.

Pressing and heat treatment of the phosphor material produces a monolithic ceramic body, which is easily sawed, machined and polished by current metallographic procedures. The monolithic polycrystalline ceramic material can be sawed into wafers, which are 1 millimeter or less in width.

Preferably, the ceramic is polished at the rear side to get a smooth surface and to improve bonding to the LED. To improve light extraction the surface of the monolithic ceramic luminescence converter may be roughened at the front side.

In a specific embodiment for manufacturing monolithic transparent europium(II)-activated strontium sulfide ceramics the fine-grained phosphor powders comprising SrS:Eu are mixed with 500 ppm CaF₂ as a sintering aid, vacuum encapsulated in molybdenum containers and sintered in a hot isostatic press (HIP) furnace to a transparent monolithic ceramic. Typical HIP conditions are 1400°C for 6 hrs at 2 kbar argon gas pressure Alternatively, the powder mixture may be hot uniaxially pressed in a graphite hot pressing die at 1300 -1500°C for 2 hrs at 1 kbar uniaxial pressure under vacuum.

Luminous output may be improved through an additional annealing step at slightly lower temperatures in flowing argon. After cooling down to room temperature the sulfide ceramics obtained were sawed into wavers. These wavers were grinded and polished to obtain the final translucent monolithic ceramics.

Another way to manufacture monolithic ceramic luminescence converters from a phosphor powder is physical vapor deposition. The aforementioned sinterable powder pigments materials are placed into a physical vapor deposition source wherein heat is applied for forming a vapor by sublimation or vaporization of the material, the vapor condensing on a substrate to provide a monolithic ceramic luminescence converter thereon. In a specific embodiment CaS:Eu(0.05%) phosphor powder is cold isostatically pressed into compacts. A covered graphite crucible containing a CaS:Eu phosphor compact is mounted in a water cooled RF-furnace that is evacuated to pressure p < 10⁻⁵ mbar. The powder sample containing part of the graphite crucible is heated up to 1600°C-1700°C for 12 hrs. Monolithic CaS:Eu is growing at the cooler top cover graphite plate of the reaction container. The CLC microstructure features a multigrain structure with only few grain boundaries.

### Monolithic ceramic luminescence converter comprising a protective coating

The monolithic ceramic luminescence converter can be coated with a protective coating in the same way as conventional phosphor pigments. Protective coatings comprising a metal oxide such as Al₂O₃, TiO₂, ZrO₂, Y₂O₃ or SiO₂ may be accomplished by any known methods, such as hydrolysis of a metal salt by heating or under alkaline conditions, which deposits hydrated metal oxide, followed by calcination. In general, the procedure involves the deposition of a precursor, which forms an amorphous metal oxide film coating on the CLCs.

In a specific embodiment a coating of silica is deposited by covering the CLC with a thin layer of nanosized silica (Aerosil) and heating up the silica powder covered ceramic luminescence converter in air to 850°C for 2 hrs to form a continuous silica coating layer. No change in quantum efficiency is observed by applying the coating.

Other coating techniques like chemical vapor deposition (CVD) are also useful.

### Illumination system comprising yellow to red-emitting CLC

According to one aspect of the invention an illumination system, comprising a radiation source and a monolithic ceramic luminescence converter comprising at least one phosphor capable of absorbing a part of light emitted by the radiation source and emitting light of wavelength different from that of the absorbed light; wherein said at least one phosphor is an alkaline earth metal sulfide of general formula AE_{1-z}S_{1-y}Se_{y}:A_{z}, wherein AE is as least one earth alkaline metal selected from the group of Mg, Ca, Sr and Ba, 0 ≤ y <1 and 0.0005 ≤ z ≤ 0.2, activated by an activator A selected from the group of Eu(II), Ce(III), Mn(II) and Pr(III). Additionally, if A is selected from the group of trivalent cations, the alkaline earth metal sulfide may also contain monovalent cations such as Li(I), Na(I), K(I), and Ag(I) for charge compensation is provided.

While the use of the present monolithic ceramic luminescence converter is contemplated for a wide array of illumination, the present invention is described with particular reference to and finds particular application to illumination systems comprising radiation sources, which are preferably semiconductor optical radiation emitters and other devices that emit optical radiation in response to electrical excitation. Semiconductor optical radiation emitters include light emitting diode LED chips, light emitting polymers (LEPs), organic light emitting devices (OLEDs), polymer light emitting devices (PLEDs), etc.

Any configuration of an illumination system which includes a light-emitting diode or an array of light-emitting diodes and a ceramic luminescence converter comprising a alkaline earth metal sulfide of general formula AE_{1-z}S_{1-y}Se_{y}:A_{z}, wherein AE is as least one earth alkaline metal selected from the group of Mg, Ca, Sr and Ba, 0 ≤ y <1 and 0.0005 ≤ z ≤ 0.2, activated by an activator A selected from the group of Eu(II), Ce(III), Mn(II) and Pr(III). Additionally, if A is selected from the group of trivalent cations, the alkaline earth metal sulfide may also contain monovalent cations such as Li(I), Na(I), K(I), and Ag(I) for charge compensation is contemplated in the present invention, preferably with addition of other well-known phosphors, which can be combined to achieve a specific color or white light when irradiated by a LED emitting primary UV or blue light as specified above.

Possible configurations useful to couple the monolithic ceramic luminescence converter to a light emitting diode or an array of light emitting diodes comprise lead frame-mounted LEDs as well as surface-mounted LEDs.

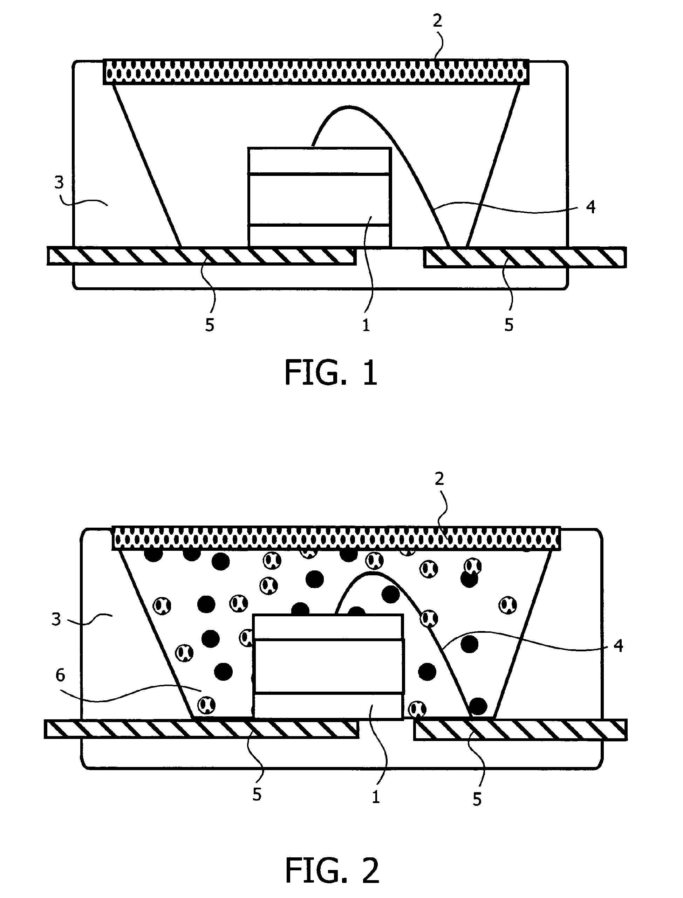

A detailed construction of one embodiment of such illumination system comprising a radiation source and a monolithic ceramic luminescence converter shown in Fig.1 will now be described.

FIG. 1 shows a schematic view of a lead-frame mounted type light emitting diode with a monolithic ceramic luminescence converter.

The light emitting diode element 1 placed within the reflection cup 3 is a small chip shaped in the form of a cube and has electrodes 5 provided at the lower and upper surface thereof respectively. The backside electrode is bonded to the cathode electrode with conductive glue. The top electrode is electrically connected to the anode electrode via a bond wire 4.

A monolithic ceramic luminescence converter 2 configured as a plate is positioned into the reflection cup in that way, that most of the light, which is emitted from the light-emitting diode, enters the plate in an angle, which is somewhat perpendicular to the surface of the plate. To achieve this, a reflector is provided around the light-emitting diode in order to reflect light that is emitted from the light-emitting diode in directions untowardly the plate.

In operation, electrical power is supplied to the LED die to activate the die. When activated, the die emits the primary light, e.g. UV or visible blue light. A portion of the emitted primary light is completely or partially absorbed by the ceramic luminescence converter. The ceramic luminescence converter then emits secondary light, i.e., the converted light having a longer peak wavelength, primarily yellow, amber and red in a sufficiently broadband in response to absorption of the primary light. The remaining unabsorbed portion of the emitted primary light is transmitted through the ceramic luminescence converter, along with the secondary light.

The reflector directs the unabsorbed primary light and the secondary light in a general direction as output light. Thus, the output light is a composite light that is composed of the primary light emitted from the die and the secondary light emitted from the luminescent layer.

The color temperature or color point of the output light of an illumination system according to the invention will vary depending upon the spectral distributions and intensities of the secondary light in comparison to the primary light.

Firstly, the color temperature or color point of the primary light can be varied by a suitable choice of the light emitting diode.

Secondly, the color temperature or color point of the secondary light can be varied by a suitable choice of the specific phosphor composition in the ceramic luminescence converter.

It should be noted that multiple luminescence converting elements could also be utilized. For example, an additional green phosphor may be needed to provide a light source that is perceived as being white by an observer. In this case, a second monolithic ceramic luminescence converter may be added. Otherwise a resin bonded luminescence converter pigment may be added as a layer coating or an emitter package.

Fig. 2 shows a schematic view of a lead-frame mounted type light emitting diode with two luminescence converters. The light emitting diode element 1 placed within the reflection cup 3 is encased in a resin package 6 that is made of a transparent polymer material such as silicon, resin or epoxy. The resin package may have a polycrystalline luminescence conversion powder material distributed throughout. The luminescence conversion material can be one or more luminescent material, such as a phosphor or a luminescent dye. The yellow, amber and red-emitting monolithic ceramic luminescence converter according to the invention is positioned on top of the resin package.

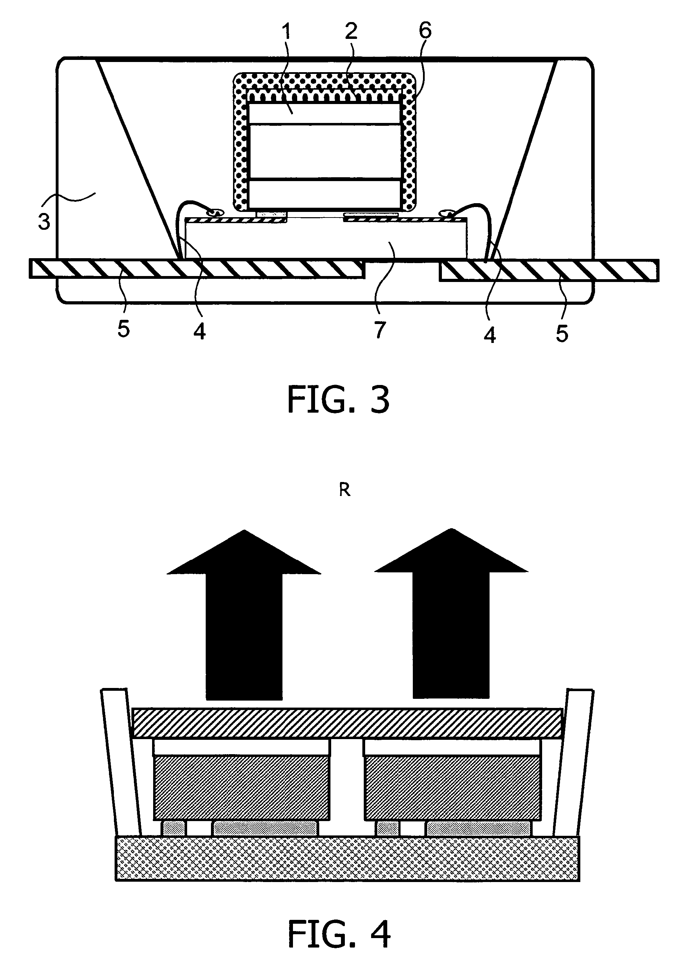

Often, light emitting diodes are fabricated on insulating substrates, such as sapphire, with both contacts on the same side of the device. Such devices may be mounted in a way that light is extracted either through the contacts, known as an epitaxy-up device, or through a surface of the device opposite the contacts, known as a flip chip device. Fig. 3 schematically illustrates a specific structure of a solid-state illumination system comprising a monolithic ceramic luminescence converter wherein the chip is packages in a flip chip configuration on a substrate with both electrodes contacting the respective leads without using bond wires. The LED die is flipped upside down and bonded onto a thermally conducting substrate. A yellow, amber and red-emitting monolithic ceramic luminescence converter according to the invention is attached to the top of the LED die.

A resin coating is formed over the exterior of the light emitting diode and the monolithic ceramic luminescence converter having dispersed therein a second polycrystalline luminescence converting material.

In operation, the light emitted by the light emitting diode is wavelength converted by the monolithic ceramic luminescence converter and mixed with the wavelength-converted light of the second luminescence converter to provide white or colored light.

Fig. 4 shows a schematic view of red lamp comprising a monolithic ceramic luminescence converter of the present invention positioned in the pathway of light emitted by light-emitting diodes with a flip chip arrangement.

Fig. 5 illustrates a schematic cross sectional view of multiple LEDs mounted on a board in combination with monolithic ceramic luminescence converters for use as a RGB display or light source.

### Phosphor converted light emitting device comprising a refractive index matched interface laver for connecting of monolithic ceramic luminescence converter and LED substrate

To reduce losses by total reflection at layer boundaries it is crucial to have a refractive index matched connection between the substrate of the light emitting diode and the monolithic ceramic color converter.

Bonding can also be realized via an intermediate Al₂O₃, SiO₂, TiO₂, ZrO₂ or Y₂O₃ containing layer, which is prepared by a conventional sol-gel method. The refractive index of the layer can be adjusted by changing the molar ratio of the constituting metal elements in the sol-gel mix. For this purpose solutions of aluminum, silicon, titanium, zirconium or yttrium alcoholates in a solvent such as ethyleneglycol-monomethylether, toluene, alcohols or ethers are used for formation of the interstitial Al₂O₃, SiO₂, TiO₂ ,ZrO₂ or Y₂O₃ containing layer. After partial hydrolysis of the alcoholates, the sols are used to coat either the monolithic ceramic luminescence converter or the substrate of the light-emitting diode or both. The two materials are then connected and the interstitial layer is transferred into a solid transparent bonding layer..

Further glass frits of high refractive index glasses (e.g. Schott LaSF 1.8/35) can be applied in between the substrate and the monolithic ceramic luminescence converter and through heating an interstitial glass layer is formed as a connection. Especially useful for bonding of monolithic alkaline earth sulfide luminescence converters are high refractive index thin-film sulfide glass systems such as BaS-Ga₂S₃-GeS₂ glasses or Ga-La-S-O glass-ceramics.

### The white light-emitting phosphor-converted light emitting device

According to one aspect of the invention the output light of the illumination system comprising a radiation source, preferably a light emitting diode, and an amber to red emitting monolithic ceramic luminescence converter according to the invention may have a spectral distribution such that it appears to be "white" light.

The most popular prior art white phosphor converted LEDs consist of a blue emitting LED chip that is coated with a phosphor that converts some of the blue radiation to a complimentary color, e.g. a yellow to amber emission. Together the blue and yellow emissions produce white light.

White LEDs, which utilize a UV emitting chip and phosphors designed to convert the UV radiation to visible light are also known. Typically, emission bands of three or more phosphor are required to producing white light.

### Blue/CLC white LED

### (Dichromatic white light phosphor converted light emitting device using blue emitting light emitting diode)

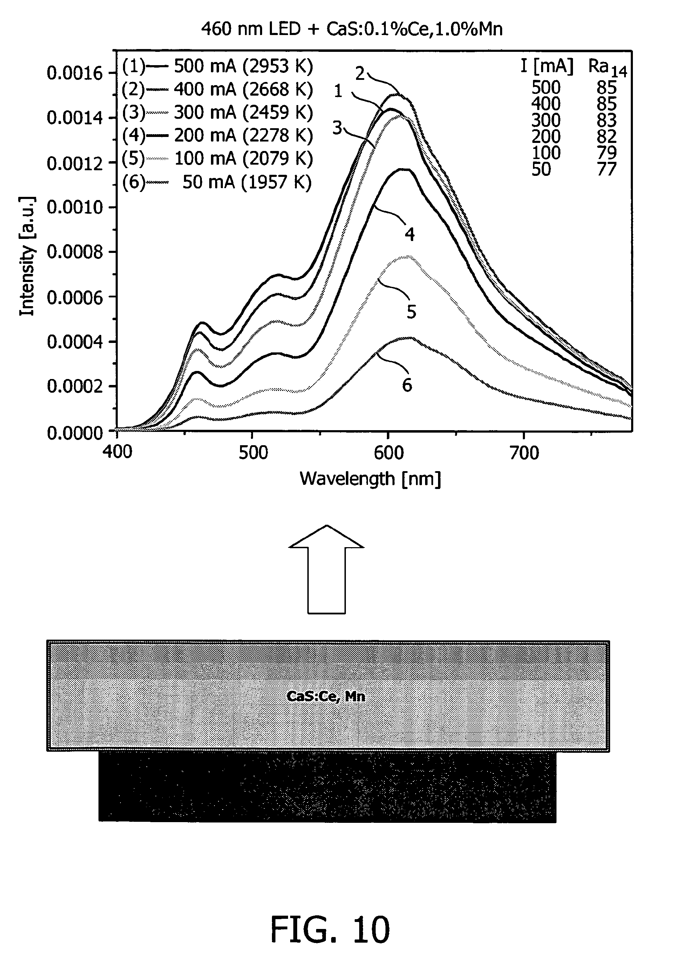

In a first embodiment of a white-light emitting illumination system according to the invention the device can advantageously be produced by choosing the luminescent material of the monolithic ceramic luminescence converter such that a blue radiation emitted by a blue light emitting diode is converted into complementary wavelength ranges in the amber range, to form dichromatic white light, as shown in Fig. 10.

Particularly good results are achieved with a blue-emitting LED whose emission maximum lies at 420 to 480 nm. An optimum has been found to lie at 455 nm, taking particular account of the excitation spectrum of the activated earth alkaline sulfides according to the invention.

Amber light is produced by means of the phosphor material of the monolithic ceramic luminescence converter, that comprises an alkaline earth metal sulfide of general formula AE_{1-z}S_{1-y}Se_{y}:A_{z}, wherein AE is as least one earth alkaline metal selected from the group of Mg, Ca, Sr and Ba, 0 ≤ y <1 and 0.0005 ≤ z ≤ 0.2, activated by an activator A selected from the group of Eu(II), Ce(III), Mn(II) and Pr(III). Additionally, if A is selected from the group of trivalent cations, the alkaline earth metal sulfide may also contain monovalent cations such as Li(I), Na(I), K(I), and Ag(I) for charge compensation.Preferably a monolithic ceramic luminescence converter comprising a phosphor of general formula CaS:Ce(0,1%),Mn(1.0%) is used.

In operation one portion of the primary blue light emitted by the LED device passes through the monolithic ceramic luminescence converter without impinging on the phosphor particles. Another portion of the primary blue radiation emitted by the LED device impinges on the activator ions of the luminescence converter, thereby causing the activator ions to emit amber light. Thus part of a blue radiation emitted by a 460 nm InGaN light emitting diode is shifted into the amber spectral region and, consequently, into a wavelength range which is complementarily colored with respect to the color Blue. A human observer perceives the combination of blue primary light and the secondary light of the amber emitting monolithic ceramic luminescence converter as white light.

### (Trichromatic white light phosphor converted light emitting device using blue emitting light emitting diode)

In a second embodiment yielding white light emission with even higher color rendering is provided by using a blue-emitting LED, an amber and red emitting monolithic ceramic luminescence converter comprising an activated earth alkaline sulfide together with a second luminescence converter, preferably a green broad band emitter

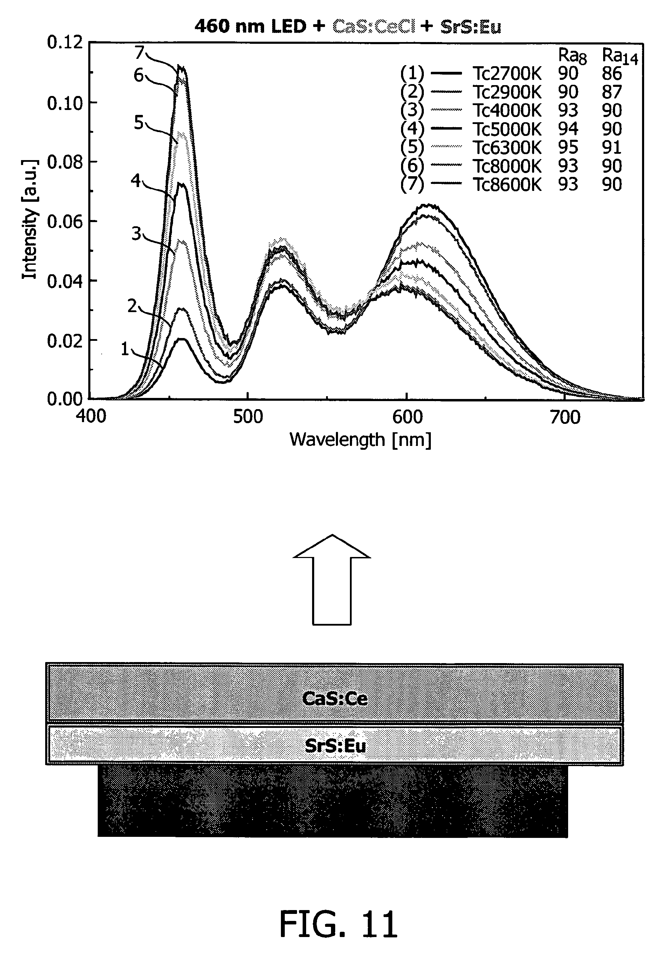

Such second luminescence converter may be either provided as a phosphor pigment admixed in a resin bonded encapsulation layer or as a second monolithic ceramic luminescence converter as shown in Fig. 11.

Useful second luminescence converters and their optical properties are summarized in the following table 2.

**Table 2:**

| **Composition** | λₘₐₓ**[nm]** | **Color point x, y** |
|---|---|---|
| (Ba₁₋ₓSrₓ)₂SiO₄:Eu | 523 | 0.272,0.640 |
| SrGa₂S₄:Eu | 535 | 0.270, 0.686 |
| SrSi₂N₂O₂:Eu | 541 | 0.356, 0.606 |
| SrS:Eu | 610 | 0.627,0.372 |
| (Sr_{1-x-y}CaₓBa_{y})₂Si₅N₈:Eu | 615 | 0.615,0.384 |
| (Sr_{1-x-y}CaₓBa_{y})₂Si₅₋ₐAlₐN₈₋ₐOₐ:Eu | 615-650 | * |
| CaS:Eu | 655 | 0.700,0.303 |
| (Sr₁₋ₓCaₓ)S:Eu | 610-655 | * |

| | | |
|---|---|---|
| * color point depending on the value of x | | |

For improved color rendition the addition of further luminescence converters may be contemplated.

In operation one portion of the primary blue radiation emitted by the LED device passes through the first and the second luminescence converter without impinging on the phosphor particles.

One portion of the primary blue radiation emitted by the LED device impinges on the activator ions of the first monolithic luminescence converter, thereby causing the activator ions to emit yellow, amber or red light.

Another portion of the primary blue radiation passes through the first luminescence converter and impinges on the second luminescence converter, thereby causing the second luminescence converter to emit green radiation

A human observer perceives the triad combination of blue primary light, secondary amber light from the monolithic ceramic luminescence converter and secondary light of the yellow- to green emitting phosphor as white light.

The hue (color point in the CIE chromaticity diagram) of the white light thereby produced can be varied by a suitable choice of the phosphors in respect of mixture and concentration.

### The amber and red light-emitting phosphor-converted light emitting device

According to another aspect of the invention the output light of the illumination system comprising a radiation source and a red emitting monolithic ceramic luminescence converter may have a spectral distribution such that it appears to be amber and red light.

The color output of an LED - CLC system is very sensitive to the thickness of the monolithic ceramic luminescence converter. If the converter thickness is high, then a lesser amount of the primary blue LED light will penetrate through the converter. The combined LED - CLC system will then appear amber and red, because it is dominated by the amber and red secondary light of the monolithic ceramic luminescence converter. Therefore, the thickness of the monolithic ceramic luminescence is a critical variable affecting the color output of the system.

A monolithic ceramic luminescence converter comprising alkaline earth metal sulfide of general formula AE_{1-z}S_{1-y}Se_{y}:A_{z}, wherein AE is as least one earth alkaline metal selected from the group of Mg, Ca, Sr and Ba, 0 ≤ y <1 and 0.0005 ≤ z ≤ 0.2, activated by an activator A selected from the group of Eu(II), Ce(III), Mn(II) and Pr(III). Additionally, if A is selected from the group of trivalent cations, the alkaline earth metal sulfide may also contain monovalent cations such as Li(I), Na(I), K(I), and Ag(I) for charge compensation as phosphor is particularly well suited as a amber and red component for stimulation by a primary blue radiation source such as, for example, a blue light emitting diode.

It is possible thereby to implement a phosphor converted light emitting device emitting in the amber and red regions of the electromagnetic spectrum.

Particularly good results are achieved with a blue-emitting LED whose emission maximum lies at 420 to 480 nm An optimum has been found to lie at 455nm, taking particular account of the excitation spectrum of activated earth alkaline sulfides according to the invention.

### DESCRIPTION OF THE DRAWINGS

FIG. 1 shows a schematic cross sectional view of a dichromatic white LED lamp comprising a ceramic luminescence converter of the present invention positioned in the pathway of light emitted by a light-emitting diode lead-frame structure.
FIG. 2 shows a schematic cross sectional view of a trichromatic white LED lamp comprising a ceramic luminescence converter of the present invention positioned in the pathway of light emitted by a light-emitting diode lead-frame structure.
Fig. 3 shows a schematic cross sectional view of a trichromatic white LED lamp comprising a ceramic luminescence converter of the present invention positioned in the pathway of light emitted by an light-emitting diode flip chip structure.
Fig. 4 shows a schematic cross sectional view of a dichromatic green lamp comprising a ceramic luminescence converters of the present invention positioned in the pathway of light emitted by an light-emitting diode flip chip structure.
Fig. 5 shows a schematic cross sectional view of a RGB display comprising ceramic luminescence converters of the present invention positioned in the pathway of light emitted by an light-emitting diode flip chip structure.
Fig. 6 shows the excitation and emission pattern of a monolithic ceramic luminescence converter comprising CaS:Eu(O.05%).
Fig.7 shows the excitation and emission pattern of a monolithic ceramic luminescence converter comprising Ca_{0.75}Sr_{0.25}S:Eu(0.05%).
Fig. 8 shows the excitation and emission pattern of a monolithic ceramic luminescence converter comprising SrS:Eu(0.05%).
Fig.9 shows the excitation and emission pattern of monolithic ceramic luminescence converters comprising a) CaS:Ce (0.1%), b) CaS:Ce,Mn (0.1,0.1%), c) CaS:Ce,Mn (0.1,0.2%), d) CaS:Ce,Mn (0.1,0.3%), e) CaS:Ce,Mn (0.1,1.0%), and f) CaS:Ce,Mn (0.1,2.0%)
Fig. 10 shows the emission spectrum and layout example of a warm white LED lamp (InGaN chip + CaS:Ce,Mn monolithic CLC)
Fig.11 shows eEmission spectrum and layout example of a warm white LED lamp (InGaN chip + SrS:Eu + CaS:Ce monolithic CLC)

### LIST OF NUMERALS

1 Light emitting diode
2 Monolithic ceramic luminescence converter
3 Reflector
4 Wirebond
5 Electrodes
6 Phosphor coating
7 Lead frame

## Claims

1. Illumination system, comprising a radiation source and a monolithic ceramic luminescence converter comprising at least one phosphor capable of absorbing a part of light emitted by the radiation source and emitting light of wavelength different from that of the absorbed light; wherein said at least one phosphor is an alkaline earth metal sulfide of general formula AE_{1-z}S_{1-y}Se_{y}:A_{z}, wherein AE is as least one earth alkaline metal selected from the group of Mg, Ca, Sr and Ba, 0 ≤ y <1 and 0.0005 ≤ z ≤ 0.2, activated by an activator A selected from the group of Eu(II), Ce(III), Mn(II) and Pr(III).

2. Illumination system according to claim 1, wherein said radiation source is a light-emitting diode.

3. Illumination system according to claim 2, comprising a protective coating attached to said monolithic ceramic luminescence converter.

4. Illumination system according to claim 3, wherein the protective comprises a ceramic material, selected from the group of silica SiO₂, alumina Al₂O₃ and yttria Y₂O₃.

5. Illumination system according to claim 3, wherein the protective comprises a glass.

6. Illumination system according to claim 1, wherein said monolithic ceramic luminescence converter is a first luminescence converter element, further comprising one or more additional luminescence converter elements.

7. Illumination system according to claim 3, wherein the additional luminescence converter element is a coating, comprising a resin-bonded phosphor pigment.

8. Illumination system according to claim 3, wherein the additional luminescence converter element is a second monolithic ceramic luminescence converter, comprising a second phosphor.

9. Monolithic ceramic luminescence converter comprising at least one phosphor capable of absorbing a part of light emitted by the radiation source and emitting light of wavelength different from that of the absorbed light; wherein said at least one phosphor is an alkaline earth metal sulfide of general formula AE_{1-z}S_{1-y}Se_{y}:A_{z} , wherein AE is as least one earth alkaline metal selected from the group ofMg, Ca, Sr and Ba, 0 ≤ y <1 and 0.0005 ≤ z ≤ 0.2, activated by an activator A selected from the group of Eu(II), Ce(III), Mn(II) and Pr(III).

## Patentansprüche

1. Beleuchtungssystem, mit einer Strahlungsquelle und einem monolithischen keramischen Lumineszenzkonverter, der zumindest einen Leuchtstoff umfasst, der imstande ist, einen Teil von von der Strahlungsquelle emittiertem Licht zu absorbieren und Licht einer Wellenlänge zu emittieren, die sich von der des absorbierten Lichtes unterscheidet; wobei der genannte zumindest eine Leuchtstoff ein Erdalkalimetallsulfid der allgemeinen Formel AE_{1-z}S_{1-y}Se_{y}:A_{z} ist, mit AE zumindest ein aus der Gruppe Mg, Ca, Sr und Ba ausgewähltes Erdalkalimetall, 0 ≤ y <1 und 0,0005 ≤ z ≤ 0,2, aktiviert durch einen aus der Gruppe Eu(II), Ce(III), Mn(II) und Pr(III) ausgewählten Aktivator A.

2. Beleuchtungssystem nach Anspruch 1, wobei die genannte Strahlungsquelle eine Leuchtdiode ist.

3. Beleuchtungssystem nach Anspruch 2, mit einer an dem genannten monolithischen keramischen Lumineszenzkonverter befestigten Schutzbeschichtung.

4. Beleuchtungssystem nach Anspruch 3, wobei die Schutzbeschichtung ein Keramikmaterial umfasst, das aus der Gruppe Siliciumdioxid SiO₂, Aluminiumoxid Al₂O₃ und Yttriumoxid Y₂O₃ ausgewählt ist.

5. Beleuchtungssystem nach Anspruch 3, wobei die Schutzbeschichtung ein Glas umfasst.

6. Beleuchtungssystem nach Anspruch 1, wobei der genannte monolithische keramische Lumineszenzkonverter ein erstes Lumineszenzkonversionselement ist, weiterhin mit einem oder mehreren zusätzlichen Lumineszenzkonversionselementen.

7. Beleuchtungssystem nach Anspruch 3, wobei das zusätzliche Lumineszenzkonversionselement eine Beschichtung ist, die ein kunstharzgebundenes Leuchtstoffpigment umfasst.

8. Beleuchtungssystem nach Anspruch 3, wobei das zusätzliche Lumineszenzkonversionselement ein zweiter monolithischer keramischer Lumineszenzkonverter ist, der einen zweiten Leuchtstoff umfasst.

9. Monolithischer keramischer Lumineszenzkonverter, der zumindest einen Leuchtstoff umfasst, der imstande ist, einen Teil von von der Strahlungsquelle emittiertem Licht zu absorbieren und Licht einer Wellenlänge zu emittieren, die sich von der des absorbierten Lichtes unterscheidet; wobei der genannte zumindest eine Leuchtstoff ein Erdalkalimetallsulfid der allgemeinen Formel AE_{1-z}S_{1-y}Se_{y}:A_{z} ist, mit AE zumindest ein aus der Gruppe Mg, Ca, Sr und Ba ausgewähltes Erdalkalimetall, 0 ≤ y <1 und 0,0005 ≤ z ≤ 0,2, aktiviert durch einen aus der Gruppe Eu(II), Ce(III), Mn(II) und Pr(III) ausgewählten Aktivator A.

## Revendications

1. Système d'éclairage comprenant une source de rayonnement et un convertisseur de luminescence céramique monolithique comprenant au moins un phosphore qui est capable d'absorber une partie de la lumière étant émise par la source de rayonnement et qui émet de la lumière ayant une longueur d'onde qui est différente de celle de la lumière absorbée; dans lequel ledit au moins un phosphore est un sulfure métallique de terre alcaline ayant la formule générale AE_{1-z}S_{1-y}Se_{y}:A_{z} dans lequel AE est au moins un métal alcalino-terreux qui est sélectionné parmi le groupe constitué de Mg, de Ca, de Sr et de Ba, 0 ≤ y < 1 et 0,0005 ≤ z ≤ 0,2, qui est activé par un activateur A qui est sélectionné parmi le groupe constitué de Eu(II), de Ce(III), de Mn(II) et de Pr(III).

2. Système d'éclairage selon la revendication 1, dans lequel ladite source de rayonnement est une diode électroluminescente.

3. Système d'éclairage selon la revendication 2, comprenant une couche de revêtement de protection qui est attachée audit convertisseur de luminescence céramique monolithique.

4. Système d'éclairage selon la revendication 3, dans lequel la couche de protection comprend un matériau céramique qui est sélectionné parmi le groupe constitué de silice SiO₂, d'oxyde d'aluminium Al₂O₃ et d'oxyde d'yttrium Y₂O₃.

5. Système d'éclairage selon la revendication 3, dans lequel la couche de protection comprend un verre.

6. Système d'éclairage selon la revendication 1, dans lequel ledit convertisseur de luminescence céramique monolithique est un premier élément de convertisseur de luminescence, comprenant encore un ou plusieurs éléments additionnels de convertisseur de luminescence.

7. Système d'éclairage selon la revendication 3, dans lequel l'élément additionnel de convertisseur de luminescence est une couche de revêtement comprenant un pigment de phosphore lié par une résine synthétique.

8. Système d'éclairage selon la revendication 3, dans lequel l'élément additionnel de convertisseur de luminescence est un deuxième convertisseur de luminescence céramique monolithique comprenant un deuxième phosphore.

9. Convertisseur de luminescence céramique monolithique comprenant au moins un phosphore qui est capable d'absorber une partie de la lumière étant émise par la source de rayonnement et qui émet de la lumière d'une longueur d'onde étant différente de celle de la lumière absorbée; dans lequel ledit au moins un phosphore est un sulfure métallique de terre alcaline ayant la formule générale AE_{1-z}S_{1-y}Se_{y}:A_{z} dans lequel AE est au moins un métal alcalino-terreux qui est sélectionné parmi le groupe constitué de Mg, de Ca, de Sr et de Ba, 0 ≤ y < 1 et 0,0005 ≤ z ≤ 0,2, qui est activé par un activateur A qui est sélectionné parmi le groupe constitué de Eu(II), de Ce(III), de Mn(II) et de Pr(III).
